# EUROPEAN PATENT SPECIFICATION

(11) **EP 4 177 960 B1**
(45) Date of publication and mention of the grant of the patent: **17.12.2025**
(21) Application number: 22204133.7
(22) Date of filing: 27.10.2022
(51) Int. Cl.: H10D 30/01, H10D 30/66, H10D 62/10

(54) **SEMICONDUCTOR POWER DEVICE WITH SHORT CIRCUIT PROTECTION AND PROCESS FOR MANUFACTURING A SEMICONDUCTOR POWER DEVICE**
HALBLEITER-LEISTUNGSBAUELEMENT MIT KURZSCHLUSSSCHUTZ UND VERFAHREN ZUR HERSTELLUNG EINES HALBLEITER-LEISTUNGSBAUELEMENTS
DISPOSITIF SEMI-CONDUCTEUR DE PUISSANCE AVEC PROTECTION CONTRE LES COURTS-CIRCUITS ET PROCÉDÉ DE FABRICATION D'UN DISPOSITIF SEMI-CONDUCTEUR DE PUISSANCE

(30) Priority: 29.10.2021 IT 202100027842
(43) Date of publication of application: 10.05.2023
(73) Proprietor: STMicroelectronics S.r.l., 20864 Agrate Brianza (MB) (IT)
(72) Inventor: CASCINO, Salvatore, 95030 GRAVINA DI CATANIA (CT) (IT); GUARNERA, Alfio, 95039 TRECASTAGNI (CT) (IT); SAGGIO, Mario Giuseppe, 95020 ACI BONACCORSI (CT) (IT)
(74) Representative: Studio Torta S.p.A.

(56) References cited:
- CN-A- 111 725 318
- JP-A- 2015 115 375
- US-B1- 11 152 503
- US-B1- 6 573 534
- LUO HOU-CAI ET AL: "Investigations of SiC VDMOSFET With Floating Island Structure Based on TCAD", IEEE TRANSACTIONS ON ELECTRON DEVICES, IEEE, USA, vol. 66, no. 5, 31 May 2019 (2019-05-31), pages 2295 - 2300, XP011720496, ISSN: 0018-9383, [retrieved on 20190419], DOI: 10.1109/TED.2019.2900384
- CEZAC N ET AL: "A NEW GENERATION OF POWER UNIPOLAR DEVICESD THE CONCEPT OF THE FLOATING ISLANDS MOS TRANSISTOR (FLIMOST)", 12TH. INTERNATIONAL SYMPOSIUM ON POWER SEMICONDUCTOR DEVICES AND IC S. ISPSD 2000. PROCEEDINGS. TOULOUSE, FRANCE, MAY 22 - 25, 2000; [INTERNATIONAL SYMPOSIUM ON POWER SEMICONDUCTOR DEVICES & IC'S], NEW YORK, NY : IEEE, US, 22 May 2000 (2000-05-22), pages 69 - 72, XP000987835, ISBN: 978-0-7803-6269-7, DOI: 10.1109/ISPSD.2000.856775

## Description

### TECHNICAL FIELD

The present invention relates to a semiconductor power device with short circuit protection and to a process for manufacturing a semiconductor power device.

### BACKGROUND

It is known that, in semiconductor power devices, the tendency to reduce the dimensions to obtain high performance can expose to various conditions of risk that mainly involve certain parameters. A significant problem not only for conventional silicon power devices, but also for those based upon special materials like silicon carbide, is that of short circuit strength, often defined through the short-circuit withstand time. The current density within devices can reach extremely high values, in particular around structures like the junctions between the body wells and the drift region. Excessively high current densities may be the cause of intense local heating and even irreversible damage. For instance, heating may trigger phenomena of uncontrolled generation of electron-hole pairs ("thermal runaway"), which result in conditions of short circuit between drain regions and source regions and may not be stopped even by switching off the device. The short-circuit withstand time indicates how much a device is able to function in given conditions of current before a thermal short circuit occurs. The longer the short-circuit withstand time, the longer a device is able to function without suffering damage.

Given that the problem is mainly linked to the current density and to the local dissipation of power, it is clear that the reduction of the dimensions (shrinkage) of the devices may have negative effects, unless the performance requirements are reduced. The reduction in dimensions encounters limits due to triggering of short circuits even in devices of silicon carbide, even though this has a thermal conductivity much higher than that of other semiconductor materials and is therefore able to dissipate the heat more efficiently.

Various circuit solutions have been proposed to prevent or circumscribe potentially dangerous conditions. However, regardless of the effectiveness, they all lead to a significant increase in terms of cost and area occupied.

The structural solutions aimed simply at reducing the ON-state drain-to-source resistance (normally denoted by R_{DSON}) lead to limited benefits that, in any case, are not sufficient to increase in a satisfactory way the short-circuit withstand time.

Consequently, as a whole the tendency to reduce the dimensions of power devices to obtain higher levels of performance is hindered by the problems due to the excessively high current density.

The aim of the present invention is to provide a semiconductor power device and a process for manufacturing a semiconductor power device that will enable the limitations described to be overcome or at least mitigated.

LUO HOU-CAI ET AL, "Investigations of SiC VDMOSFET With Floating Island Structure Based on TCAD", IEEE TRANSACTIONS ON ELECTRON DEVICES, IEEE, USA, vol. 66, no. 5, doi:10.1109/TED.2019.2900384, ISSN 0018-9383, pages 2295 - 2300, discloses a semiconductor power device having a maximum rated voltage and comprising a semiconductor body containing silicon carbide and having a first conductivity type. The semiconductor power device has a first conduction terminal on a first face of the semiconductor body and a second conduction terminal on a second face of the semiconductor body. Body wells having a second conductivity type are housed in the semiconductor body and separated from one another by a body distance and source regions are housed in the body wells and are connected to the first conduction terminal. A gate region extends on the semiconductor body between the source regions. Floating pockets having the second conductivity type are formed in the semiconductor body at a distance from the body wells between the first face and the second face of the semiconductor body. The floating pockets are shaped and arranged relative to the body wells so that a maximum intensity of electrical field around the floating pockets is greater than a maximum intensity of electrical field around the body wells at least for values of an operating voltage between the first conduction terminal and the second conduction terminal higher than a threshold voltage, the threshold voltage being less than the maximum rated voltage.

Other examples of semiconductor power device are known from CN 111 725 318 A, US 11,152,503 B1, US 6,573,534 B1 and JP 2015 115375 A.

### SUMMARY

According to the present invention a semiconductor power device and a process for manufacturing a semiconductor power device are provided, as defined in claims 1 and 13, respectively.

### BRIEF DESCRIPTION OF THE DRAWINGS

For a better understanding of the invention, some embodiments thereof will now be described, purely by way of non-limiting example and with reference to the attached drawings, wherein:
- Figure 1 is a cross-sectional view through a semiconductor power device according to an embodiment of the present invention;
- Figure 1A is an equivalent electrical symbol of the power device of Figure 1;
- Figures 2 and 3 are graphs relative to a distribution of intensity of electrical field in a known power device and in the power device of Figure 1, respectively;
- Figure 4 is a graph that shows short-circuit withstand times in a known power device and in the power device of Figure 1;
- Figures 5 and 6 are graphs relative to a distribution of potential in a known power device and in the power device of Figure 1, respectively;
- Figure 7 is a cross-sectional view through a semiconductor power device according to a different embodiment of the present invention;
- Figure 8 is a cross-sectional view through a semiconductor power device according to a further embodiment of the present invention; and
- Figures 9-13 are cross-sectional views of a semiconductor wafer during successive steps of a process for manufacturing a semiconductor power device according to an embodiment of the present invention.

### DESCRIPTION OF EMBODIMENTS

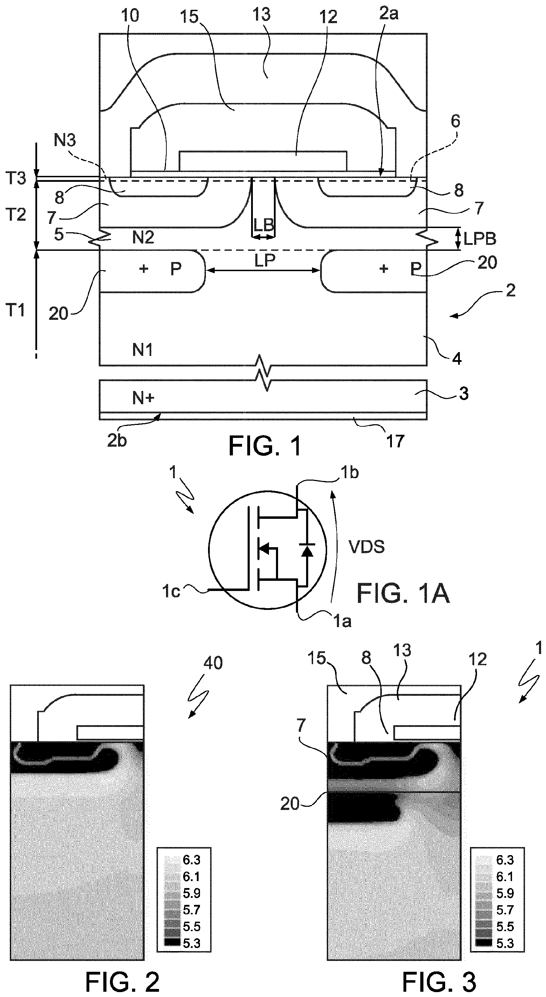

With reference to Figures 1 and 1A, a semiconductor power device according to an embodiment of the present invention is designated, as a whole, by the number 1, has a source terminal 1a, a drain terminal 1b and a gate terminal 1c and comprises a semiconductor body 2 of silicon carbide. The semiconductor body 2, in turn, comprises a substrate 3, a first epitaxial layer 4, formed on the substrate 3 and having a first thickness T1, and a second epitaxial layer 5, formed on the first epitaxial layer 4 and having a second thickness T2 smaller than the first thickness T1. For instance, the first thickness T1 is comprised in the range 10-30 µm, and the second thickness T2 is comprised in the range 0.8-2 µm. The first epitaxial layer 4 and the second epitaxial layer 5 both have a first conductivity type, for example of an N type. The first epitaxial layer 4 has, however, a first doping level N1 lower than a second doping level N2 of the second epitaxial layer. For instance, the first doping level N1 is in the order of 10¹⁶ atoms/cm³, whereas the second doping level N2 is in the order of 10¹⁷ atoms/cm³. In an embodiment, the semiconductor body 2 also comprises an enrichment layer 6, having a third thickness T3 smaller than the first thickness T1 and the second thickness T2 (for example 0.1 µm), the first conductivity type (N), and a third doping level N3 higher than the first doping level N1 and the second doping level N2. The enrichment layer 6 may be a further epitaxial layer or may be obtained by implantation. The substrate 3 is of an N+ type and has a doping level, for example, in the order of 10¹⁸ atoms/cm³.

Body wells 7, having a second conductivity type, here of a P type, are formed within the second epitaxial layer 5 and house respective source regions 8, with the first conductivity type, in particular of an N+ type. The second epitaxial layer 5 defines a current spread layer (CSL), which extends to a greater depth from a first face 2a of the semiconductor body 2 as compared to the body wells 7, and the body wells 7 are embedded in the current spread layer. In other words, the second thickness T2 of the second epitaxial layer 5, which corresponds to the depth of the current spread layer, is greater than the depth of the body wells 7 from the first face 2a.

The body wells 7 are separated from one another by a body distance LB of less than 1 µm, for example 0.6 µm. The body wells 7 and the portion of the second epitaxial layer 5 comprised between them forms a parasitic-JFET region. A gate dielectric layer 10 extends on the first face 2a of the semiconductor body 2 over the second epitaxial layer 5 (or over the enrichment layer 6, if present) between the source regions 8 and is surmounted by a gate region 12. A source contact 13 extends over the source regions 8 and the gate region 12. An intermetal dielectric layer 15 insulates the gate region 12 from the source contact 13. A drain contact 17 is formed on a second face 2b of the semiconductor body 2 opposite to the first face 2a.

At an interface with the overlying epitaxial layer, i.e., the second epitaxial layer 5, the first epitaxial layer 4 houses floating protection pockets 20 having the second conductivity type, for example of a P+ type, with a doping level in the order of 10¹⁸ atoms/cm³. Furthermore, the floating pockets 20 are shaped and arranged relative to the structures in the semiconductor body 2 so that the maximum intensity of the electrical field around the floating pockets 20 is greater than the maximum intensity of the electrical field around the body wells 7 at least for values of drain-to-source voltage VDS higher than a threshold voltage. The threshold voltage is less than a maximum rated voltage, for example equal to 25%, or to 50% or to 65% of the maximum rated voltage. The maximum rated voltage is the maximum drain-source voltage at which a device, in particular the power device 1, may safely operate. The maximum rated voltage is obviously lower than the breakdown voltage of power device 1 and is defined at design stage in accordance with the structural characteristics of the device and with the breakdown voltage. The floating pockets 20 are arranged underneath corresponding body wells 7 and are separated from one another by a protection distance LP greater than the body distance LB, for example, a difference between the protection distance LP and the body distance LB is comprised between 0.5 µm and 1.5 µm. A protection-to-body distance LPB between the floating pockets 20 and the corresponding body wells 7 in a direction perpendicular to the faces 2a and 2b of the semiconductor body 2 is less than 0.5 µm. In practice, the depth of the body wells 7 from the first face 2a of the semiconductor body 2 is at the most 0.5 µm less than the second thickness T2 of the second epitaxial layer 5.

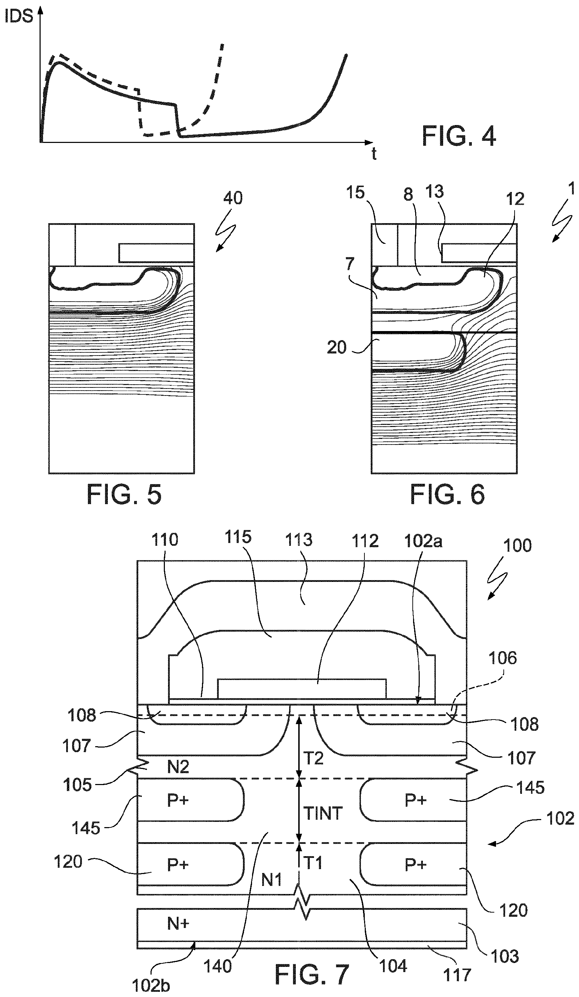

The power device 1 may be configured to operate with a gate-to-source voltage of 18 V, a maximum rated voltage (maximum drain-to-source voltage VDS) beyond 1 kV, for example 1.2 kV or 3.3 kV, and currents of even several hundreds of amps or even higher. The floating pockets 20, as defined above, enable reduction of the intensity of the electrical field around the most critical regions, i.e., the junctions between the body wells 7 and the second epitaxial layer 5, where the combination with the particularly high current density is unfavourable, also due to the dimensions of the parasitic-JFET region. The situation of the electrical field is represented in Figures 2 and 3 directly and, furthermore, in Figures 5 and 6 through potential lines, respectively for a conventional power device 40 (Figures 2 and 5) and for the power device 1 of Figure 1 (Figures 3 and 6). As may be noted, in the conventional power device, the potential lines are particularly crowded around the body well and the values of electrical field are accordingly high. In the power device 1, instead, above the threshold voltage and in conditions of conduction the potential lines are less crowded in the entire parasitic-JFET region and become more crowded around the floating pockets 20. In practice, then, the higher values of electrical field become deeper in the first epitaxial layer 4, where, however, the current density is markedly reduced because the region between the floating pockets 20 is much wider than the parasitic-JFET region. In this way, the time necessary for triggering the phenomena that lead in an uncontrolled way to short circuit due to excessive local heating, i.e., the short-circuit withstand time, is advantageously increased, as illustrated in the graph of Figure 4. Here, the dashed line refers to a conventional power device, whereas the solid line refers to the power device 1 according to the invention.

The effect of reduction of the electrical field in the critical regions around the body wells 7 and the corresponding increase of the short-circuit withstand time is also favoured by the protection-to-body distance LPB between the floating pockets 20 and the body wells 7. The protection-to-body distance LPB is in fact selected so that, at least for values of drain-to-source voltage VDS higher than the threshold voltage, the potential lines tend not to wrap around the body wells 7 and instead tend to stretch out towards the floating pockets 20, without penetrating or penetrating only marginally into the portion of the second epitaxial layer 5 comprised between the floating pockets 20 and the body wells 7. A greater distance would not allow stretching out of the potential lines and the corresponding reduction of the electrical field in the critical zones, in particular in the parasitic-JFET region.

A further advantage is represented by the fact that the improvement of the short-circuit withstand time is made possible without altering significantly either the breakdown voltage or the ON-state drain-to-source resistance, normally denoted as R_{DSON}. Rather, also an increase in the thickness of the current spread layer defined by the second epitaxial layer 5 in the order of 10-20% does not affect the breakdown voltage, which instead decreases in conventional power devices.

With reference to Figure 7, in an embodiment a semiconductor power device 100 comprises a semiconductor body 102 of silicon carbide that includes, substantially as already described, a first epitaxial layer 104 and a second epitaxial layer 105, where body wells 107 and source regions 108 are formed. An enrichment layer 106 may be present on the surface of the semiconductor body 102. As in the embodiment of Figure 1, formed on a first face 102a of the semiconductor body 102 are a gate dielectric layer 110, a gate region 112, a source contact 113 and an intermetal dielectric layer 115. A drain contact 117 is formed on a second face 102b of the semiconductor body 102 opposite to the first face 102a.

The semiconductor body 102 furthermore comprises an intermediate epitaxial layer 140, arranged between the first epitaxial layer 104 and the second epitaxial layer 105 and having a thickness TINT substantially equal to the thickness T2 of the second epitaxial layer 105 (for example, comprised in the range 0.8-2 µm).

The doping levels diminish from the second epitaxial layer 105 (the highest, if an enrichment layer is not present, for example 10¹⁷ atoms/cm³), to the intermediate epitaxial layer 140 (which is intermediate also in doping, in addition to its position, for example 4 x 10¹⁶ atoms/cm³) and to the first epitaxial layer 104 (the lowest, for example 10¹⁶ atoms/cm³). In the case where the enrichment layer 106 is present, its doping level is the highest, for example 3 x 10¹⁷ atoms/cm³.

At an interface with the overlying epitaxial layer, in this case the intermediate epitaxial layer 140, the first epitaxial layer 104 houses deep floating protection pockets 120 having the second conductivity type, for example of a P+ type with a doping level in the order of 10¹⁸ atoms/cm³.

At an interface with the second epitaxial layer 105, the intermediate epitaxial layer 140 houses intermediate floating pockets 145 that are substantially the same as the deep floating pockets 120.

The deep floating pockets 120 and the intermediate floating pockets 145 are shaped and arranged relative to the structures in the semiconductor body 102 so that the maximum intensity of the electrical field around the deep floating pockets 120 is greater than the maximum intensity of the electrical field around the body wells 107 at least for values of drain-to-source voltage VDS higher than a threshold voltage, which is less than a maximum rated voltage. In particular, distances in a direction perpendicular to the faces 102a, 102b of the semiconductor body 102 between the deep floating pockets 120 and the intermediate floating pockets 145 and between the intermediate floating pockets 145 and the body wells 107 are less than 0.5 µm, for example 0.3 µm. These distances are not necessarily the same as one another.

The presence of protection wells on a number of levels enables amplification of the effect of translation of the high values of electrical field towards the inside of the semiconductor body 102, at a greater distance from the first face 102a.

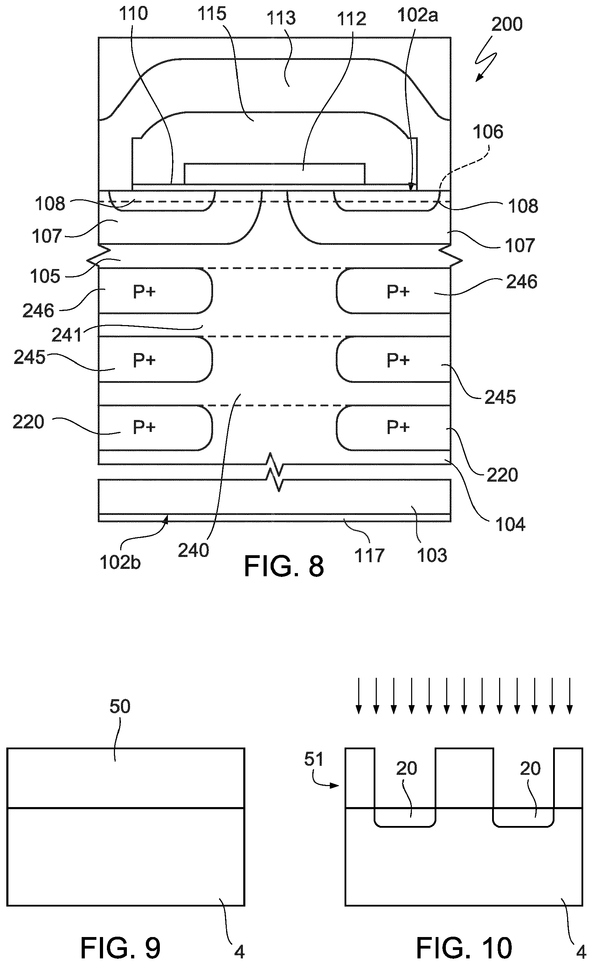

The number of levels of protection wells is not limited to two. In other embodiments, as in the semiconductor power device 200 of Figure 8, in addition to the deep protection wells here designated by 220, there may be present, for example, two intermediate levels of protection wells 245, 246, or even a higher number, according to the design preferences. The intermediate floating pockets of each level are formed in respective intermediate epitaxial layers 240, 241.

The power device 1 of Figure 1 may be manufactured with the process described in the following with reference to Figures 9-13. Initially, the first epitaxial layer 4 is formed for the desired thickness. Then, a first mask layer 50 of TEOS (TetraEthylOrthoSilicate) is deposited and planarized.

The first mask layer 50 is then patterned (Figure 10) to form a first implantation mask 51, which is then used for producing the floating pockets 20 by a first implantation P as far as the desired depth. The first implantation P in an embodiment is a multiple implantation in a number of steps, which enables a precise control of the implantation depth and of the shape of the floating pockets 20. The implanted dopant species may be aluminium, and the implantation may be performed in five steps, as defined in the table below.

| Dopant species | Concentration [atoms/cm³] | Implantation energy [keV] |
|---|---|---|
| Al + | 10¹² | 30 |
| Al + | 10¹² | 80 |
| Al + | 10¹³ | 160 |
| Al ++ | 3.12 x 10¹³ | 300 |
| Al ++ | 5.20 x 10¹³ | 400 |

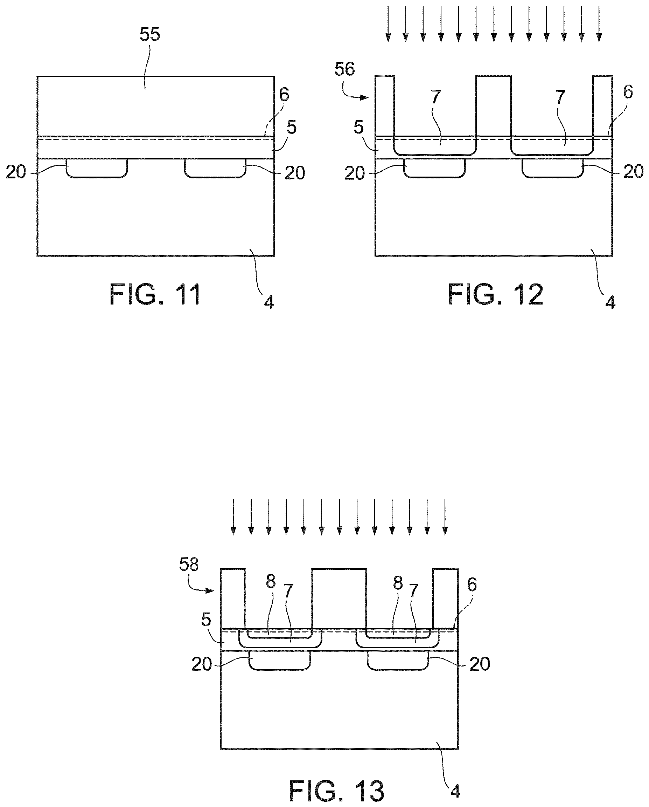

After removal of the first implantation mask 1, the second epitaxial layer 5 is grown, once again for the desired thickness (Figure 11). If necessary, the enrichment layer 6 is formed through a further epitaxial growth or by surface implantation of dopant species.

A second mask layer 55 is deposited and planarized, and then patterned to form a second implantation mask 56 (Figure 12), which is used to produce the body wells 7 by a second implantation P as far as the desired depth. Also the second implantation may be a multiple implantation.

The second implantation mask 56 is removed, and a third implantation mask 58 is formed (Figure 13) from a mask layer (not illustrated entirely) with which the source regions 8 are formed.

The third implantation mask 58 is removed, and the power device 1 is completed with the gate dielectric layer 10, the gate region 12, the intermetal dielectric layer 15, and the source contact 13, and finally by producing the source terminal 1a, the drain terminal 1b, and the gate terminal 1c (Figure 1A).

Finally, it is clear that modifications and variations may be made to the device and to the process described herein, without thereby departing from the scope of the present invention, as defined in the annexed claims.

## Claims

1. A semiconductor power device having a maximum rated voltage and comprising:
a semiconductor body (2; 102) containing silicon carbide and having a first conductivity type;
a first conduction terminal (1a) on a first face (2a; 102a) of the semiconductor body (2; 102) and a second conduction terminal (1b) on a second face (2b; 102b) of the semiconductor body (2; 102);
body wells (7; 107) having a second conductivity type, housed in the semiconductor body and separated from one another by a body distance (LB);
source regions housed in the body wells (7) and connected to the first conduction terminal (1a);
a gate region (12) extending on the semiconductor body (2; 102) between the source regions (8; 108); and
floating pockets (20; 120) having the second conductivity type, formed in the semiconductor body (2; 102) at a distance from the body wells (7; 107) between the first face (2a; 102a) and the second face (2b; 102b) of the semiconductor body (2; 102);
wherein the floating pockets (20; 120) are shaped and arranged relative to the body wells (7; 107) so that a maximum intensity of electrical field around the floating pockets (20; 120) is greater than a maximum intensity of electrical field around the body wells (7; 107) at least for values of an operating voltage (VDS) between the first conduction terminal (1a) and the second conduction terminal (1b) higher than a threshold voltage, the threshold voltage being less than the maximum rated voltage;
**characterized in that**:
the semiconductor body (2; 102) comprises a first epitaxial layer (4; 104), having the first conductivity type and a first doping level (N1), and a second epitaxial layer (5; 105), having the first conductivity type and a second doping level (N2), higher than the first doping level (N1);
the body wells (7; 107) are housed in the second epitaxial layer (5; 105); and
the floating pockets (20; 120) are housed in the first epitaxial layer (4; 104) at an interface of the first epitaxial layer (4; 104) with an epitaxial layer overlying the first epitaxial layer (4; 104);
wherein the second epitaxial layer (5; 105) defines a current spread layer, which extends up to a greater depth from the first face (2a; 102a) of the semiconductor body (2; 102) than the body wells (7; 107).

2. The device according to claim 1, wherein the epitaxial layer overlying the first epitaxial layer (4) is the second epitaxial layer (5).

3. The device according to claim 2, wherein a protection-to-body distance (LPB) between the floating pockets (20) and the corresponding body wells (7) in a direction perpendicular to the first face (2a) and to the second face (2b) of the semiconductor body (2) is less than 0.5 µm.

4. The device according to claim 1, wherein the semiconductor body (102) comprises an intermediate epitaxial layer (140), arranged between the first epitaxial layer (104) and the second epitaxial layer (105) and having a doping level intermediate between the first doping level (N1) and the second doping level (N2), and wherein the epitaxial layer overlying the first epitaxial layer (104) is the intermediate epitaxial layer (140).

5. The device according to claim 4, comprising intermediate floating pockets (145) having the second conductivity type, formed in the intermediate epitaxial layer (140) at an interface with the second epitaxial layer (105).

6. The device according to claim 4 or claim 5, wherein distances in a direction perpendicular to the first face (102a) and to the second face (102b) of the semiconductor body (102) between the floating pockets (120) and the intermediate floating pockets (145) and between the intermediate floating pockets (145) and the body wells (107) are less than 0.5 µm.

7. The device according to any one of the preceding claims, wherein the semiconductor body (2; 102) comprises a surface enrichment layer (6; 106), having a third doping level (N3) higher than the first doping level (N1) and the second doping level (N2) and wherein the first epitaxial layer (104) has a first thickness (T1), the second epitaxial layer (105) has a second thickness (T2), and the enrichment layer (6; 106) has a third thickness (T3) smaller than the first thickness (T1) and the second thickness (T2).

8. The device according to any one of the preceding claims, wherein the body wells (7; 107) are separated from one another by a body distance (LB) and wherein the floating pockets (20; 120) are arranged underneath corresponding body wells (7; 107) and are separated from one another by a protection distance (LP) greater than the body distance (LB).

9. The device according to claim 8, wherein the protection distance (LP) is greater than the body distance (LB) by an amount comprised between 0.5 µm and 1.5 µm.

10. The device according to any one of the preceding claims, wherein the body distance (LB) is less than 1 µm.

11. The device according to claim 10, wherein the body distance (LB) is 0.6 µm.

12. The device according to any one of the preceding claims, wherein the floating pockets (20; 120) have the second conductivity type and a doping level in the order of 10¹⁸ atoms/cm³.

13. A process for manufacturing a semiconductor power device comprising:
forming a semiconductor body (2; 102) containing silicon carbide and having a first conductivity type (N);
forming body wells (7; 107) having a second conductivity type (P), housed in the semiconductor body and separated from one another by a body distance (LB);
forming source regions (8) having the first conductivity type (N) and housed in the body wells (7); and
forming floating pockets (20; 120) having the second conductivity type in the semiconductor body (2; 102) at a distance from the body wells (7; 107) between a first face (2a; 102a) and a second face (2b; 102b) of the semiconductor body (2; 102);
forming a first conduction terminal (1a) connected to the source regions (8) on the first face (2a; 102a) of the semiconductor body (2; 102) and a second conduction terminal (1b) on the second face (2b; 102b) of the semiconductor body (2; 102); and
forming a gate region (12) extending on the semiconductor body (2; 102) between the source regions (8; 108);
wherein the floating pockets (20; 120) are shaped and arranged relative to the body wells (7; 107) so that a maximum intensity of electrical field around the floating pockets (20; 120) is greater than a maximum intensity of electrical field around the body wells (7; 107) at least for values of an operating voltage (VDS) between the first conduction terminal (1a) and the second conduction terminal (1b) greater than a threshold voltage, the threshold voltage being less than a maximum rated voltage;
**characterized in that**:
forming the semiconductor body (2; 102) comprises forming a first epitaxial layer (4; 104), having the first conductivity type and a first doping level (N1), and a second epitaxial layer (5; 105), having the first conductivity type and a second doping level (N2) higher than the first doping level (N1);
the floating pockets (20; 120) are formed in the first epitaxial layer (4; 104) at an interface of the first epitaxial layer (4; 104) with an epitaxial layer overlying the first epitaxial layer (4; 104);
and the body wells (7; 107) are formed in the second epitaxial layer (5; 105);
wherein the second epitaxial layer (5; 105) defines a current spread layer, which extends up to a greater depth from the first face (2a; 102a) of the semiconductor body (2; 102) than the body wells (7; 107).

14. The process according to claim 13, wherein forming floating pockets (20) comprises forming a first implantation mask (51) on the first epitaxial layer (4) and carrying out a first implantation, for example a first multiple implantation, of a dopant species of the second type using the first implantation mask (51); and wherein forming body wells (7) comprises forming a second implantation mask (56) and carrying out a second implantation, for example a second multiple implantation, of a dopant species of the second type using the second implantation mask (56).

15. The process according to claim 14, wherein the first implantation is a first multiple implantation and the second implantation is a second multiple implantation.

## Patentansprüche

1. Halbleiter-Leistungsvorrichtung, die eine maximale Nennspannung aufweist und umfasst:
einen Halbleiterkörper (2; 102), der Siliziumkarbid enthält und einen ersten Leitfähigkeitstyp aufweist;
einen ersten Leitungsanschluss (1a) an einer ersten Fläche (2a; 102a) des Halbleiterkörpers (2; 102) und einen zweiten Leitungsanschluss (1b) an einer zweiten Fläche (2b; 102b) des Halbleiterkörpers (2; 102);
Körpermulden (7; 107), die einen zweiten Leitfähigkeitstyp aufweisen, die in dem Halbleiterkörper untergebracht sind und um einen Körperabstand (LB) voneinander getrennt sind;
Quellbereiche, die in den Körpermulden (7) untergebracht sind und mit dem ersten Leitungsanschluss (1a) verbunden sind;
einen Gate-Bereich (12), der sich auf dem Halbleiterkörper (2; 102) zwischen den Quellbereichen (8; 108) erstreckt; und
schwimmende Fächer (20; 120), die den zweiten Leitfähigkeitstyp aufweisen, die in dem Halbleiterkörper (2; 102) in einem Abstand von den Körpermulden (7; 107) zwischen der ersten Fläche (2a; 102a) und der zweiten Fläche (2b; 102b) des Halbleiterkörpers (2; 102) gebildet sind;
wobei die schwimmenden Fächer (20; 120) in Bezug zu den Körpermulden (7; 107) geformt und angeordnet sind, sodass eine maximale Intensität des elektrischen Feldes um die schwimmenden Fächer (20; 120) mindestens für Werte einer Betriebsspannung (VDS) zwischen dem ersten Leitungsanschluss (1a) und dem zweiten Leitungsanschluss (1b), die höher als eine Schwellenspannung sind, größer ist als eine maximale Intensität des elektrischen Feldes um die Körpermulden (7; 107), wobei die Schwellenspannung kleiner als die maximale Nennspannung ist; **dadurch gekennzeichnet, dass**:
der Halbleiterkörper (2; 102) eine erste Epitaxieschicht (4; 104), die den ersten Leitfähigkeitstyp und eine erste Dotierungsstufe (N1) aufweist, und eine zweite Epitaxieschicht (5; 105) umfasst, die den ersten Leitfähigkeitstyp und eine zweite Dotierungsstufe (N2) aufweist, die höher ist als die erste Dotierungsstufe (N1);
die Körpermulden (7; 107) in der zweiten Epitaxieschicht (5; 105) untergebracht sind; und
die schwimmenden Fächer (20; 120) in der ersten Epitaxieschicht (4; 104) an einer Schnittstelle der ersten Epitaxieschicht (4; 104) mit einer die erste Epitaxieschicht (4; 104) überlagernden Epitaxieschicht untergebracht sind;
wobei die zweite Epitaxieschicht (5; 105) eine Stromverteilerschicht definiert, die sich bis zu einer größeren Tiefe von der ersten Fläche (2a; 102a) des Halbleiterkörpers (2; 102) als die Körpermulden (7; 107) erstreckt.

2. Vorrichtung nach Anspruch 1, wobei die Epitaxieschicht, welche die erste Epitaxieschicht (4) überlagert, die zweite Epitaxieschicht (5) ist.

3. Vorrichtung nach Anspruch 2, wobei ein Schutz-KörperAbstand (LPB) zwischen den schwimmenden Fächern (20) und den entsprechenden Körpermulden (7) in einer Richtung senkrecht zur ersten Fläche (2a) und zur zweiten Fläche (2b) des Halbleiterkörpers (2) weniger als 0,5 µm beträgt.

4. Vorrichtung nach Anspruch 1, wobei der Halbleiterkörper (102) eine Epitaxie-Zwischenschicht (140) umfasst, die zwischen der ersten Epitaxieschicht (104) und der zweiten Epitaxieschicht (105) angeordnet ist und eine Dotierungsstufe aufweist, die zwischen der ersten Dotierungsstufe (N1) und der zweiten Dotierungsstufe (N2) liegt, und wobei die Epitaxieschicht, welche die erste Epitaxieschicht (104) überlagert, die Epitaxie-Zwischenschicht (140) ist.

5. Vorrichtung nach Anspruch 4, die schwimmende Zwischenfächer (145) umfasst, die den zweiten Leitfähigkeitstyp aufweisen, die in der Epitaxie-Zwischenschicht (140) an einer Schnittstelle zur zweiten Epitaxieschicht (105) gebildet sind.

6. Vorrichtung nach Anspruch 4 oder Anspruch 5, wobei die Abstände in einer Richtung senkrecht zur ersten Fläche (102a) und zur zweiten Fläche (102b) des Halbleiterkörpers (102) zwischen den schwimmenden Fächern (120) und den schwimmenden Zwischenfächern (145) und zwischen den schwimmenden Zwischenfächern (145) und den Körpermulden (107) weniger als 0,5 µm betragen.

7. Vorrichtung nach einem der vorstehenden Ansprüche, wobei der Halbleiterkörper (2; 102) eine Oberflächenanreicherungsschicht (6; 106) umfasst, die eine dritte Dotierungsstufe (N3) aufweist, die höher ist als die erste Dotierungsstufe (N1) und die zweite Dotierungsstufe (N2) und wobei die erste Epitaxieschicht (104) eine erste Dicke (T1) aufweist, die zweite Epitaxieschicht (105) eine zweite Dicke (T2) aufweist, und die Anreicherungsschicht (6; 106) eine dritte Dicke (T3) kleiner als die erste Dicke (T1) und die zweite Dicke (T2) aufweist.

8. Vorrichtung nach einem der vorstehenden Ansprüche, wobei die Körpermulden (7; 107) um einen Körperabstand (LB) voneinander getrennt sind und die schwimmenden Fächer (20; 120) unter den entsprechenden Körpermulden (7; 107) angeordnet sind, und um einen Schutzabstand (LP) voneinander getrennt sind, der größer ist als der Körperabstand (LB).

9. Vorrichtung nach Anspruch 8, wobei der Schutzabstand (LP) um einen Betrag größer ist als der Körperabstand (LB), der zwischen 0,5 µm und 1,5 µm umfasst ist.

10. Vorrichtung nach einem der vorstehenden Ansprüche, wobei der Körperabstand (LB) weniger als 1 µm beträgt.

11. Vorrichtung nach Anspruch 10, wobei der Körperabstand (LB) 0,6 µm beträgt.

12. Vorrichtung nach einem der vorstehenden Ansprüche, wobei die schwimmenden Fächer (20; 120) den zweiten Leitfähigkeitstyp und eine Dotierungsstufe in der Größenordnung von 10¹⁸ Atomen/cm³ aufweisen.

13. Verfahren zur Herstellung einer Halbleiter-Leistungsvorrichtung, umfassend:
Bilden eines Halbleiterkörpers (2; 102), der Siliziumkarbid enthält und einen ersten Leitfähigkeitstyp (N) aufweist;
Bilden von Körpermulden (7; 107), die einen zweiten Leitfähigkeitstyp (P) aufweisen, die in dem Halbleiterkörper untergebracht und um einen Körperabstand (LB) voneinander getrennt sind;
Bilden von Quellbereichen (8), die den ersten Leitfähigkeitstyp (N) aufweisen, und in den Körpermulden (7) untergebracht sind; und
Bilden von schwimmenden Fächern (20; 120), die den zweiten Leitfähigkeitstyp aufweisen, in dem Halbleiterkörper (2; 102) in einem Abstand von den Körpermulden (7; 107) zwischen einer ersten Fläche (2a; 102a) und einer zweiten Fläche (2b; 102b) des Halbleiterkörpers (2; 102);
Bilden eines ersten Leitungsanschlusses (1a), der mit den Quellbereichen (8) an der ersten Fläche (2a; 102a) des Halbleiterkörpers (2; 102) verbunden ist und eines zweiten Leitungsanschlusses (1b) an der zweiten Fläche (2b; 102b) des Halbleiterkörpers (2; 102); und
Bilden eines Gate-Bereichs (12), der sich auf dem Halbleiterkörper (2; 102) zwischen den Quellbereichen (8; 108) erstreckt;
wobei die schwimmenden Fächer (20; 120) in Bezug zu den Körpermulden (7; 107) geformt und angeordnet sind, sodass eine maximale Intensität des elektrischen Feldes um die schwimmenden Fächer (20; 120) mindestens für Werte einer Betriebsspannung (VDS) zwischen dem ersten Leitungsanschluss (1a) und dem zweiten Leitungsanschluss (1b), die größer als eine Schwellenspannung sind, größer ist als die maximale Intensität des elektrischen Feldes um die Körpermulden (7; 107), wobei die Schwellenspannung kleiner als die maximale Nennspannung ist;
**dadurch gekennzeichnet, dass**:
Bilden des Halbleiterkörpers (2; 102) die Herstellung einer ersten Epitaxieschicht (4; 104), die den ersten Leitfähigkeitstyp und eine erste Dotierungsstufe (N1) aufweist, und einer zweiten Epitaxieschicht (5; 105) umfasst, die den ersten Leitfähigkeitstyp und eine zweite Dotierungsstufe (N2) aufweist, die höher ist als die erste Dotierungsstufe (N1);
die schwimmenden Fächer (20; 120) in der ersten Epitaxieschicht (4; 104) an einer Schnittstelle der ersten Epitaxieschicht (4; 104) mit einer die erste Epitaxieschicht (4; 104) überlagernden Epitaxieschicht gebildet sind;
und die Körpermulden (7; 107) in der zweiten Epitaxieschicht (5; 105) gebildet sind;
wobei die zweite Epitaxieschicht (5; 105) eine Stromverteilerschicht definiert, die sich bis zu einer größeren Tiefe von der ersten Fläche (2a; 102a) des Halbleiterkörpers (2; 102) als die Körpermulden (7; 107) erstreckt.

14. Verfahren nach Anspruch 13, wobei Bilden von schwimmenden Fächern (20) Bilden einer ersten Implantationsmaske (51) auf der ersten Epitaxieschicht (4) und Durchführen einer ersten Implantation, beispielsweise einer ersten Mehrfachimplantation, einer Dotiersubstanz des zweiten Typs unter Verwendung der ersten Implantationsmaske (51) umfasst; und wobei Bilden von Körpermulden (7) Bilden einer zweiten Implantationsmaske (56) und Durchführen einer zweiten Implantation, beispielsweise einer zweiten Mehrfachimplantation, einer Dotiersubstanz des zweiten Typs unter Verwendung der zweiten Implantationsmaske (56) umfasst.

15. Verfahren nach Anspruch 14, wobei die erste Implantation eine erste Mehrfachimplantation und die zweite Implantation eine zweite Mehrfachimplantation ist.

## Revendications

1. Dispositif de puissance à semi-conducteur présentant une tension nominale maximale et comprenant :
un corps semi-conducteur (2 ; 102) contenant du carbure de silicium et présentant un premier type de conductivité ;
une première borne de conduction (1a) sur une première face (2a ; 102a) du corps semi-conducteur (2 ; 102) et une seconde borne de conduction (1b) sur une seconde face (2b ; 102b) du corps semi-conducteur (2 ; 102) ;
des puits de corps (7 ; 107) présentant un second type de conductivité, logés dans le corps semi-conducteur et séparés les uns des autres par une distance de corps (LB) ; des régions sources logées dans les puits du corps (7) et reliées à la première borne de conduction (1a) ;
une région de grille (12) s'étendant sur le corps semi-conducteur (2 ; 102) entre les régions sources (8 ; 108) ; et
des poches flottantes (20 ; 120) présentant le second type de conductivité, formées dans le corps semi-conducteur (2 ; 102) à une distance des puits de corps (7 ; 107) entre la première face (2a ; 102a) et la seconde face (2b ; 102b) du corps semi-conducteur (2 ; 102) ;
dans lequel les poches flottantes (20 ; 120) sont formées et agencées par rapport aux puits de corps (7 ; 107) de sorte qu'une intensité maximale de champ électrique autour des poches flottantes (20 ; 120) est supérieure à une intensité maximale de champ électrique autour des puits de corps (7 ; 107) au moins pour des valeurs d'une tension de fonctionnement (VDS) entre la première borne de conduction (1a) et la seconde borne de conduction (1b) supérieure à une tension seuil, la tension seuil étant inférieure à la tension nominale maximale ; **caractérisé en ce que** :
le corps semi-conducteur (2 ; 102) comprend une première couche épitaxiale (4 ; 104), présentant le premier type de conductivité et un premier niveau de dopage (N1), et une seconde couche épitaxiale (5 ; 105), présentant le premier type de conductivité et un deuxième niveau de dopage (N2), supérieur au premier niveau de dopage (N1) ;
les puits de corps (7 ; 107) sont logés dans la seconde couche épitaxiale (5 ; 105) ; et
les poches flottantes (20 ; 120) sont logées dans la première couche épitaxiale (4 ; 104) au niveau d'une interface de la première couche épitaxiale (4 ; 104) avec une couche épitaxiale recouvrant la première couche épitaxiale (4 ; 104) ;
dans lequel la seconde couche épitaxiale (5 ; 105) définit une couche de diffusion de courant, qui s'étend jusqu'à une profondeur plus grande à partir de la première face (2a ; 102a) du corps semi-conducteur (2 ; 102) que les puits de corps (7 ; 107).

2. Dispositif selon la revendication 1, dans lequel la couche épitaxiale recouvrant la première couche épitaxiale (4) est la seconde couche épitaxiale (5).

3. Dispositif selon la revendication 2, dans lequel une distance de protection au corps (LPB) entre les poches flottantes (20) et les puits de corps (7) correspondants dans une direction perpendiculaire à la première face (2a) et à la seconde face (2b) du corps semi-conducteur (2) est inférieure à 0,5 µm.

4. Dispositif selon la revendication 1, dans lequel le corps semi-conducteur (102) comprend une couche épitaxiale intermédiaire (140), agencée entre la première couche épitaxiale (104) et la seconde couche épitaxiale (105) et présentant un niveau de dopage intermédiaire entre le premier niveau de dopage (N1) et le deuxième niveau de dopage (N2), et dans lequel la couche épitaxiale recouvrant la première couche épitaxiale (104) est la couche épitaxiale intermédiaire (140).

5. Dispositif selon la revendication 4, comprenant des poches flottantes intermédiaires (145) présentant le second type de conductivité, formées dans la couche épitaxiale intermédiaire (140) au niveau d'une interface avec la seconde couche épitaxiale (105).

6. Dispositif selon la revendication 4 ou la revendication 5, dans lequel des distances dans une direction perpendiculaire à la première face (102a) et à la seconde face (102b) du corps semi-conducteur (102) entre les poches flottantes (120) et les poches flottantes intermédiaires (145) et entre les poches flottantes intermédiaires (145) et les puits de corps (107) sont inférieures à 0,5 µm.

7. Dispositif selon l'une quelconque des revendications précédentes, dans lequel le corps semi-conducteur (2 ; 102) comprend une couche d'enrichissement de surface (6 ; 106), présentant un troisième niveau de dopage (N3) supérieur au premier niveau de dopage (N1) et au deuxième niveau de dopage (N2), et dans lequel la première couche épitaxiale (104) a une première épaisseur (T1), la seconde couche épitaxiale (105) a une deuxième épaisseur (T2), et la couche d'enrichissement (6 ; 106) a une troisième épaisseur (T3) inférieure à la première épaisseur (T1) et à la deuxième épaisseur (T2).

8. Dispositif selon l'une quelconque des revendications précédentes, dans lequel les puits de corps (7 ; 107) sont séparés les uns des autres par une distance de corps (LB) et où les poches flottantes (20 ; 120) sont agencées sous les puits de corps (7 ; 107) correspondants et sont séparées les unes des autres par une distance de protection (LP) supérieure à la distance de corps (LB).

9. Dispositif selon la revendication 8, dans lequel la distance de protection (LP) est supérieure à la distance de corps (LB) d'une valeur comprise entre 0,5 µm et 1,5 µm.

10. Dispositif selon l'une quelconque des revendications précédentes, dans lequel la distance de corps (LB) est inférieure à 1 µm.

11. Dispositif selon la revendication 10, dans lequel la distance de corps (LB) est de 0,6 µm.

12. Dispositif selon l'une quelconque des revendications précédentes, dans lequel les poches flottantes (20 ; 120) présentent le second type de conductivité et un niveau de dopage de l'ordre de 10¹⁸ atomes/cm³.

13. Procédé de fabrication d'un dispositif de puissance à semi-conducteur comprenant :
la formation d'un corps semi-conducteur (2 ; 102) contenant du carbure de silicium et présentant un premier type de conductivité (N) ;
la formation de puits de corps (7 ; 107) présentant un second type de conductivité, logés dans le corps semi-conducteur et séparés les uns des autres par une distance de corps (LB) ;
la formation de régions sources (8) présentant le premier type de conductivité (N) et logées dans les puits de corps (7) ; et
la formation de poches flottantes (20 ; 120) présentant le second type de conductivité dans le corps semi-conducteur (2 ; 102) à une distance des puits de corps (7 ; 107) entre une première face (2a ;102a) et une seconde face (2b ; 102b) du corps semi-conducteur (2 ; 102) ;
la formation d'une première borne de conduction (1a) connectée aux régions sources (8) sur la première face (2a ; 102a) du corps semi-conducteur (2 ; 102) et d'une seconde borne de conduction (1b) sur la seconde face (2b ; 102b) du corps semi-conducteur (2 ; 102) ; et
la formation d'une région de grille (12) s'étendant sur le corps semi-conducteur (2 ; 102) entre les régions sources (8 ; 108) ;
dans lequel les poches flottantes (20 ; 120) sont formées et agencées par rapport aux puits de corps (7 ; 107) de sorte qu'une intensité maximale de champ électrique autour des poches flottantes (20 ; 120) est supérieure à une intensité maximale de champ électrique autour des puits de corps (7 ; 107) au moins pour des valeurs d'une tension de fonctionnement (VDS) entre la première borne de conduction (1a) et la seconde borne de conduction (1b) supérieure à une tension seuil, la tension seuil étant inférieure à une tension nominale maximale ;
**caractérisé en ce que** :
la formation du corps semi-conducteur (2 ; 102) comprend la formation d'une première couche épitaxiale (4 ; 104), présentant le premier type de conductivité et un premier niveau de dopage (N1), et d'une seconde couche épitaxiale (5 ; 105), présentant le premier type de conductivité et un deuxième niveau de dopage (N2) supérieur au premier niveau de dopage (N1) ;
les poches flottantes (20 ; 120) sont formées dans la première couche épitaxiale (4 ; 104) au niveau d'une interface de la première couche épitaxiale (4 ; 104) avec une couche épitaxiale recouvrant la première couche épitaxiale (4 ; 104) ;
et les puits de corps (7 ; 107) sont formés dans la seconde couche épitaxiale (5 ; 105) ;
dans lequel la seconde couche épitaxiale (5 ; 105) définit une couche de diffusion de courant, qui s'étend jusqu'à une profondeur plus grande à partir de la première face (2a ; 102a) du corps semi-conducteur (2 ; 102) que les puits de corps (7 ; 107).

14. Procédé selon la revendication 13, dans lequel la formation de poches flottantes (20) comprend la formation d'un premier masque d'implantation (51) sur la première couche épitaxiale (4) et la réalisation d'une première implantation, par exemple une première implantation multiple, d'une espèce dopante de second type à l'aide du premier masque d'implantation (51) ; et dans lequel la formation de puits de corps (7) comprend la formation d'un second masque d'implantation (56) et la réalisation d'une seconde implantation, par exemple une seconde implantation multiple, d'une espèce dopante de second type à l'aide du second masque d'implantation (56).

15. Procédé selon la revendication 14, dans lequel la première implantation est une première implantation multiple et la seconde implantation est une seconde implantation multiple.
